# EUROPEAN PATENT APPLICATION

(11) **EP 3 954 749 A1**
(43) Date of publication of application: **16.02.2022**
(21) Application number: 20210162.2
(22) Date of filing: 27.11.2020
(51) Int. Cl.: C09K 11/64

(54) **SULFIDE PHOSPHOR AND LIGHT-EMITTING DEVICE COMPRISING THE SAME**

(30) Priority: 10.08.2020 KR 20200099850
(71) Applicant: Industry Academy Cooperation Foundation Of Sejong University, Seoul 05006 (KR)
(72) Inventor: SOHN, Kee-sun, 06057 Gangnam-gu , Seoul (KR); KIM, Min-seuk, 01781 Nowon-gu, Seoul (KR)
(74) Representative: Beck & Rössig European Patent Attorneys

(57) **Abstract**

The present invention relates to a sulfide phosphor including a parent body containing one or more selected from Ba, Li, and S, and Al and Ga as constituent elements, wherein one or more activators selected from Eu and Ce are employed to the parent body.

## Description

### BACKGROUND OF THE INVENTION

### 1. Field of the Invention

The present invention relates to a phosphor having a new crystal structure and a light-emitting device including the phosphor, and more particularly, to a new sulfide phosphor and a light-emitting device using the same, wherein the sulfide phosphor includes a sulfide containing barium, lithium, and aluminum, and may emit light in the range of a green color wavelength when a blue light-emitting diode is used as an excitation source.

### 2. Description of the Related Art

A white LED light-emitting device, which has been in the spotlight recently for being used for lighting, LCD backlight, automotive lighting, and the like, include an LED light-emitting element which typically emits blue light or ultraviolet light and a phosphor which converts a wavelength into visible light using the light emitted the light-emitting element as an excitation source.

As a method for implementing such a white LED light-emitting device, a blue light-emitting diode using an InGaN-based material with a wavelength of 450 to 550 nm is typically used as a light-emitting element, and a yellow light emitting YAG-based phosphor represented by a composition formula of (Y,Gd)₃(Al,Ga)₅O₁₂ is typically used a phosphor. In such a white LED light-emitting device, the blue light emitted from the light-emitting element is incident on a phosphor layer and absorbed and scattered repeatedly for several times in the phosphor layer. In this process, the blue light absorbed by the phosphor is subjected to wavelength conversion and becomes yellow light, and the yellow light and a portion of the incident blue light are mixed to appear white to the human eye.

However, the white LED light-emitting device of such a structure has a problem in that only illumination light with poor color rendering properties may be obtained since the red component is low, the color temperature is high, and the red and green components are insufficient in the light. In order to address the above problem, research has been actively conducted to develop a green phosphor to compensate for lacking components of a typical LED light-emitting device.

Prior art document: Korean Patent Registration No. 0835069.

### SUMMARY OF THE INVENTION

The invention provides a phosphor having a new crystal structure not known the art, emitting light with excellent luminance in the range of a green color wavelength, and having a very high light-emission attenuation rate, and thus, may be suitably used as a phosphor for displays such as LED or LED lighting, and provides a light-emitting device including the phosphor.

According to one aspect of the invention, there is provided a sulfide phosphor including a parent body containing one or more selected from Ba, Li, and S, and Al and Ga as a constituent element, wherein one or more activators selected from Eu and Ce are employed to the parent body.

According to another aspect of the invention, there is provided a light-emitting device including a sulfide phosphor and including a light-emitting element which emits excitation light and a wavelength-converting unit which absorbs the excitation light and emits visible light, wherein the wavelength-converting unit includes a parent body containing one or more selected from Ba, Li, and S, and Al and Ga as a constituent element, wherein one or more activators selected from Eu and Ce are employed to the parent body.

### ADVANTAGEOUS EFFECTS

The structure and use of a phosphor composition having Ba, Li, and Al, and/or Ga and S as a parent body and using an activator as in the invention have not been reported so far. The composition may be used as a green phosphor or a cyan phosphor in Eu and Ce doping, and may be suitably used as a phosphor for LEDs and a phosphor for displays since it has excellent light efficiency and a high attenuation rate.

### BRIEF DESCRIPTION OF THE DRAWINGS

FIG. 1 shows the X-ray diffraction pattern of a phosphor produced according Example 1 of the invention;
FIG. 2 shows the X-ray diffraction pattern of a phosphor produced according Example 2 of the invention;
FIG. 3 shows the PL properties of a phosphor produced according Example 1 of the invention;
FIG. 4 shows the PL properties of a phosphor produced according Example 2 of the invention;
FIG. 5 shows the PL properties of a phosphor produced according Example 3 of the invention;
FIG. 6 shows the PL properties of a phosphor produced according Example 4 of the invention; and
FIG. 7 shows the attenuation rate of a phosphor produced according to Example 1 of the invention compared with the attenuation rate of other commercial phosphors (β-SIALON and CASN).

### DETAILED DESCRIPTION OF THE EXEMPLARY EMBODIMENTS

Hereinafter, specific details for carrying out the invention will be described in detail.

### Phosphor

A phosphor according to the invention is characterized in that it is a sulfide phosphor including a parent body containing one or more selected from Ba, Li, and S, and Al and Ga as a constituent element, wherein one or more activators selected from Eu and Ce are employed to the parent body.

Preferably, when the relative intensity of a diffraction peak having the highest intensity in a powder X-ray diffraction pattern is set to 100%, the powder parent body includes a phase showing a diffraction peak of 5% or more of the relative intensity in a range in which the Bragg angle (2θ) of the X-ray diffraction pattern is 17.4° to 18.4°, 24.7° to 25.7°, 28.5° to 29.5°, 31.2° to 32.2°, 33.5° to 34.5° 35.5° to 36.5° as a main phase.

In addition, the phosphor may be preferably composed of [Composition Equation 1] below.

[Composition Equation 1] BaₐLi_{b}A_{C}Sₓ : Ln_{z}

(wherein 0.5≤a≤2, 0.5≤b≤1.5, 0.5≤c≤1.5, 2.5≤x≤7.5, and 0.001≤z/a≤0.2, A is one or more selected from Al and Ga, and Ln is an activator).

In addition, the parent body of the phosphor may have a monoclinic crystal structure.

In addition, the lattice constant of the main phase of the parent body is = 8.212 a, b = 6.951 a, and c = 7.186 a, and the lattice constants may vary by ± 5%.

In addition, the parent body of the phosphor may preferably have a molar ratio of Ba:Li:A:S of 2:1:1:4.

In addition, the phosphor may have a light emission wavelength of 465 to 600 nm for an excitation wavelength of 300 to 470 nm.

In addition, in the phosphor, when A is Ba, Ba may be replaced by Eu with a molar ratio of 20% or lower.

In addition, in the phosphor, when A is Al or Ga, a portion of Al or Ga may be replaced by Ce with a molar ratio of 20% or lower.

In addition, in the phosphor, when the high capacity (x) of the activator (Ln) is less than 0.001 in a molar ratio, the luminance is not sufficient due to the lack of light-emitting elements, and when greater than 0.2, the luminance is rather decreased to the effect of so-called concentration quenching. Therefore, a range of 0.001 to 0.2 is preferable in that high luminance may be achieved, and a molar ratio range of 0.005 to 0.05 is more preferable. In addition, as the activator, Eu is most preferred, and doping of Ce is also possible.

In addition, it is ideal that a phosphor having the composition according to the invention is composed of a single phase. However, in a production process, a small amount of amorphous phases or other crystalline phases which are not monoclinic may be inevitably included in the phosphor. That is, even a mixture including such amorphous phases or other crystalline phases may be partially included as long as it does not affect properties.

In addition, the range of the average particle size of the phosphor according to the invention is preferably 1 to 20 µm. When the average particle size is less than 1 µm, light absorption rate is degraded, and the phosphor may not be uniformly dispersed in a resin for sealing an LED. When the average particle size is greater than 20 µm, light emission intensity and color tones may not be uniform.

In addition, a light-emitting device according to the invention is characterized by including a light-emitting element which emits excitation light, and a wavelength-converting unit which absorbs the excitation light and emits visible light, wherein the wavelength-converting unit includes a parent body containing one or more selected from Ba, Li, and S, and Al and Ga as a constituent element, wherein one or more activators selected from Eu and Ce are employed to the parent body.

The light-emitting element may be any light source in which light emitted from the element may be introduced to the wavelength-converting unit to generate a green light or a cyan light.

The light-emitting element may preferably be a blue light light-emitting element or a UV light light-emitting element having a peak wavelength of about 365 to 480 nm.

The light-emitting element may be an ultraviolet light-emitting diode or a blue light-emitting diode.

### Method for producing phosphor

As for raw materials for producing a phosphor, in the case of Ba, Li, Al, Ga, Eu, and Ce, which are main components, barium sulfate (BaS), lithium sulfide (Li₂S), aluminum sulfide (Al₂S₃), gallium sulfide (Ga₂S₃), europium oxide (Eu₂O₃), and cerium oxide (CeO₂) powders were used. The raw materials were weighed and mixed so as to have a predetermined composition. At this time, the amount of a mixture per sample was 1 g. The above raw materials were manually mixed for 20 minutes in an argon atmosphere in a glove box.

Mixture samples obtained as described above are fired in an atmosphere of hydrogen and nitrogen gases containing 0 to 25% H₂, wherein hydrogen and nitrogen gases are main components, with an atmospheric pressure of at least 20 atm. When firing is performed in an atmosphere of hydrogen and nitrogen gases as described above, the oxidation of sulfides synthesized during the firing may be prevented or suppressed, and the composition variation among generated sulfides may be reduced, so that a phosphor composition having excellent performance may be produced. Meanwhile, having hydrogen and nitrogen gases as main components means that less than 25% of hydrogen gas and more than 75% of nitrogen gas are included in total gases.

In addition, the firing temperature is preferably 600 to 1000°C, and in order to obtain a high-quality phosphor, 700°C or higher is more preferable. In addition, the firing time may be set to be within a range of 30 minutes to 100 hours. When considering quality, productivity, and the like, 2 hours to 24 hours are preferable. In the present embodiment, a phosphor was produced by performing firing for 4 hours at a firing temperature of 700°C in an atmospheric Air gas atmosphere, followed by crushing.

Hereinafter, the sulfide phosphor of the invention will be described in detail with reference to more specific examples.

### [Example 1]

As raw material powders of a phosphor composition of Example 1, 0.7596 g of BaS, 0.0526 g of Li₂S, 0.1718 g of Al₂S₃, and 0.0160 g of Eu₂O₃ were each weighed, and then mixed by hand using a mortar in an argon atmosphere in a glove box to obtain 1 g of a raw material powder mixture. 1 g of the raw material powder mixture obtained as described above was charged into a crucible, and 500 cc of hydrogen/nitrogen gas was flowed into a firing furnace per minute to perform firing treatment of heating the mixture at 700° C for 4 hours. Thereafter, a phosphor composition was obtained followed by pulverization. When the phosphor composition was excited with a 450 nm light source, it was confirmed that the composition emits green light.

The production process conditions of the phosphor mixture according to Example 1 and the emission wavelength of the produced phosphor are shown in Table 1 below.

**[Table 1]**

| Example s | Raw material composition | | | Activator | |
|---|---|---|---|---|---|
| | BaS (g) | Li₂S (g) | Al₂S₃ (g) | Material | Mixed amount (g) |
| 1 | 0.7596 | 0.0526 | 0.1718 | Eu₂O₃ | 0.0161 |

### [Example 2]

As raw material powders of a phosphor composition of Example 2, 0.4661 g of BaS, 0.1935 g of Li₂S, 0.3308 g of Ga₂S₃, and 0.0097 g of CeO₂ were each weighed, and then mixed by hand using a mortar in an argon atmosphere in a glove box to obtain 1 g of a raw material powder mixture. 1 g of the raw material powder mixture obtained as described above was charged into a crucible, and 500 cc of hydrogen/nitrogen gas was flowed into a firing furnace per minute to perform firing treatment of heating the mixture at 700° C for 4 hours. Thereafter, a phosphor composition was obtained followed by pulverization. When the phosphor composition was excited with a 450 nm light source, it was confirmed that the composition emits green light.

The production process conditions of the phosphor mixture according to Example 2 and the emission wavelength of the produced phosphor are shown in Table 2 below.

**[Table 2]**

| Examples | Raw material composition | | | Activator | |
|---|---|---|---|---|---|
| | BaS (g) | Li₂S (g) | Ga₂S₃ (g) | Material | Mixed amount (g) |
| 2 | 0.4661 | 0.1935 | 0.3308 | CeO₂ | 0.0097 |

### [Example 3]

As raw material powders of a phosphor composition of Example 3, 0.5120 g of BaS, 0.2126 g of Li₂S, 0.0908 g of Ga₂S₃, 0.1737 g of Al₂S₃, and 0.0109 g of Eu₂O₃ were each weighed, and then mixed by hand using a mortar in an argon atmosphere in a glove box to obtain 1 g of a raw material powder mixture. 1 g of the raw material powder mixture obtained as described above was charged into a crucible, and 500 cc of hydrogen/nitrogen gas was flowed into a firing furnace per minute to perform firing treatment of heating the mixture at 800° C for 4 hours. Thereafter, a phosphor composition was obtained followed by pulverization. When the phosphor composition was excited with a 450 nm light source, it was confirmed that the composition emits green light.

The production process conditions of the phosphor mixture according to Example 3 and the emission wavelength of the produced phosphor are shown in Table 3 below.

**[Table 3]**

| Examples | Raw material composition | | | | Activator | |
|---|---|---|---|---|---|---|
| | BaS (g) | Li₂S (g) | Al₂S₃(g) | Ga₂S₃(g) | Material | Mixed amount (g) |
| 3 | 0.5120 | 0.2126 | 0.1731 | 0.0908 | Eu₂O₃ | 0.0109 |

### [Example 4]

As raw material powders of a phosphor composition of Example 4, 0.4805 g of BaS, 0.1995 g of Li₂S, 0.2557 g of Ga₂S₃, 0.0543 g of Al₂S₃, and 0.0109 g of CeO₂ were each weighed, and then mixed by hand using a mortar in an argon atmosphere in a glove box to obtain 1 g of a raw material powder mixture. 1 g of the raw material powder mixture obtained as described above was charged into a crucible, and 500 cc of hydrogen/nitrogen gas was flowed into a firing furnace per minute to perform firing treatment of heating the mixture at 800° C for 4 hours. Thereafter, a phosphor composition was obtained followed by pulverization. When the phosphor composition was excited with a 400 nm light source, it was confirmed that the composition emits light in the range of a blue color wavelength to a green color wavelength.

The production process conditions of the phosphor mixture according to Example 4 and the emission wavelength of the produced phosphor are shown in Table 4 below.

**[Table 4]**

| Examples | Raw material composition | | | | Activator | |
|---|---|---|---|---|---|---|
| | BaS (g) | Li₂S (g) | Al₂S₃ (g) | Ga₂S₃ (g) | Material | Mixed amount (g) |
| 4 | 0.4805 | 0.1995 | 0.0543 | 0.2557 | CeO₂ | 0.0100 |

The light-emitting properties of each of the phosphor compositions prepared as described above were analyzed using powder XRD analysis and a PL apparatus.

### XRD analysis results

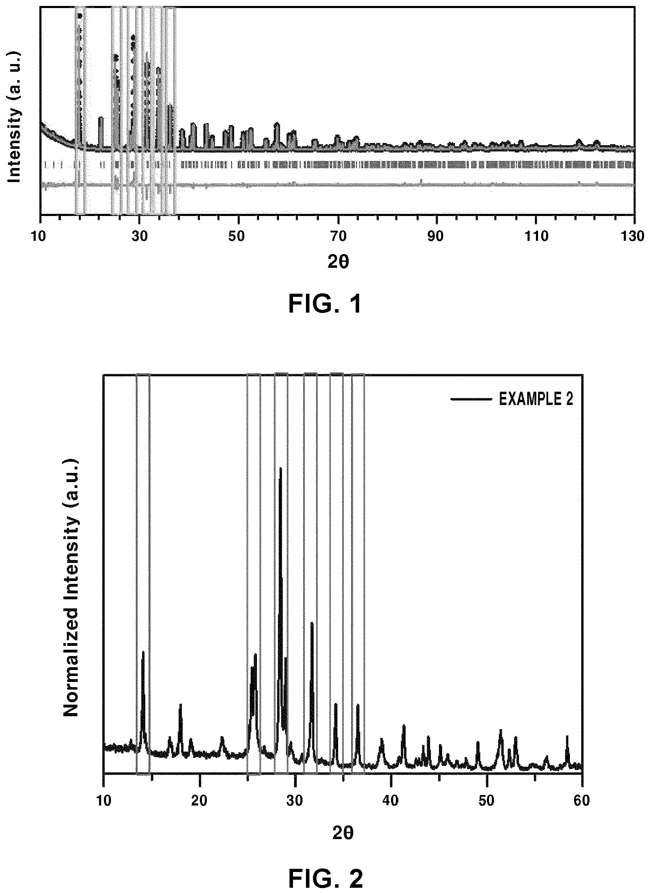

FIG. 1 shows the X-ray diffraction pattern of the phosphor produced according Example 1 of the invention, and FIG. 2 shows the X-ray diffraction pattern of the phosphor produced according Example 2 of the invention.

As confirmed in FIG. 1, when Rietveld refinement was performed using the X-ray diffraction pattern of the phosphor produced according to Example 1, the phosphor showed a crystal structure having a peak with a relative intensity of 10% or more in a portion in which the Bragg angle (2θ) of the X-ray diffraction pattern was 17.4° to 18.4°, 24.7° to 25.7°, 28.5° to 29.5°, 31.2° to 32.2°, 33.5° to 34.5°, and 35.5° to 36.5°, when the relative intensity of a diffraction peak having the highest intensity (maximum intensity peak) was set to 100%.

The results of structural analysis through Rietveld refinement of the X-ray diffraction pattern for the phosphor composition produced according to Example 1 of the invention are shown in Table 5 below.

**[Table 5]**

| atom | Wyckof f site | x/a | y/b | z/c | B (Å²) | SOF |
|---|---|---|---|---|---|---|
| Ba1 | 2e | 0.3114(4) | 0.25 | 0.2465 (3) | 0.02(3) | 1.00 |
| Ba2 | 2e | 0.8137(4) | 0.25 | 0.2524(4) | 0.02(7) | 1.00 |
| S1 | 2b | 0.5 | 0 | 0 | 0.25 (6) | 1.00 |
| S2 | 2a | 0 | 0 | 0 | 0.57(8) | 1.00 |
| S3 | 2e | 0.137(1) | 0.25 | 0.5928 (8) | 0.18(8) | 1.00 |
| S4 | 2e | 0.655(2) | 0.25 | 0.6207(8) | 0.37(8) | 1.00 |
| Al | 2e | 0.931(1) | 0.25 | 0.7801(7) | 0.001 (4) | 1.00 |
| Li | 2e | 0.4383(6) | 0.25 | 0.7615(6) | 0.5 | 1.00 |
| Compound Name: Ba₂Li Al S₄ | | | | | | |
| Wavelength (µ): 1.5216Å | | | | | | |
| Space group: *P*2₁/m | | | | | | |
| Space group No: 11 | | | | | | |
| Z (formula unit per unit cell): 2 | | | | | | |
| Lattice parameters: a = 8.21247(3)Å, b = 6.9508(3)Å, c =7.18584(4)Å ; α = η = 90 and β =106.5709 (6) °Rₚ = 8.51, R_{wp} = 12.1, Rₑₓₚ= 6.39 and γ² = 3.58 | | | | | | |

From the crystal structure information obtained through the Rietveld refinement, it can be seen that among materials composed of sulfides containing Ba, Li, and Al as essential components as in Example 1 of the invention, no material having the above-described crystal structure has been reported. That is, it can be said that Example 1 of the invention is a novel material.

Meanwhile, as confirmed in FIG. 2, when Rietveld refinement was performed using the X-ray diffraction pattern of the phosphor produced according to Example 2, the phosphor showed a crystal structure having a peak with a relative intensity of 5% or more in a portion in which the Bragg angle (2θ) of the X-ray diffraction pattern was 17.4° to 18.4°, 24.7° to 25.7°, 28.5° to 29.5°, 31.2° to 32.2°, 33.5° to 34.5°, and 35.5° to 36.5°, when the relative intensity of a diffraction peak having the highest intensity (maximum intensity peak) was set to 100%.

However, among materials composed of sulfides containing Ba, Li, and Al as essential components as in Example 2 of the invention, no material having a crystal structure which shows the above-described peak at the above-described Bragg angle has been reported. That is, it can be said that Example 2 of the invention is also a novel material as Example 1.

### PL analysis results

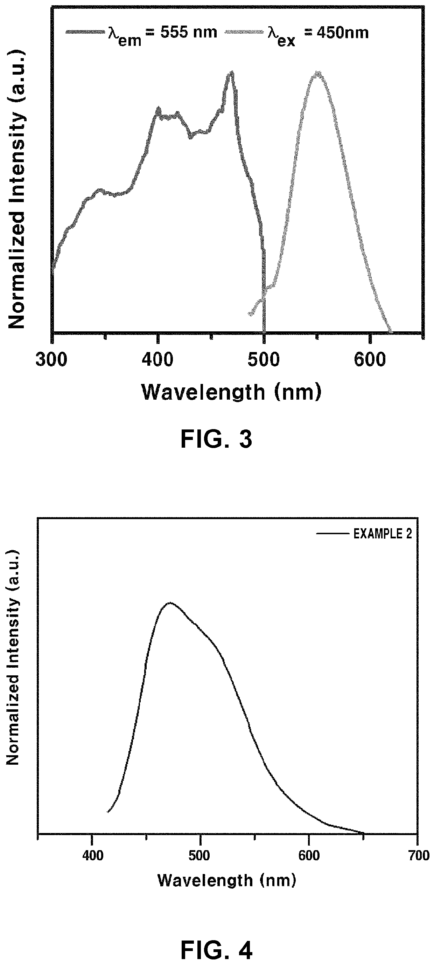

FIG. 3 shows the PL properties of the phosphor produced according Example 1 of the invention, and FIG. 4 shows the PL properties of the phosphor produced according Example 2 of the invention.

As confirmed in FIG. 3, the phosphor according to Example 1 of the invention exhibited a light emission wavelength of 555 nm for an excitation light of 450 nm. That is, since light is emitted in the range of a green color wavelength, it can be seen that the phosphor may be applied as a green phosphor.

As confirmed in FIG. 4, the phosphor according to Example 2 of the invention exhibited a light emission wavelength of 555 nm for an excitation light of 450 nm. That is, since light is emitted in the range between a green color wavelength and a blue color wavelength, it can be seen that the phosphor may be used for tuning the above color wavelength region.

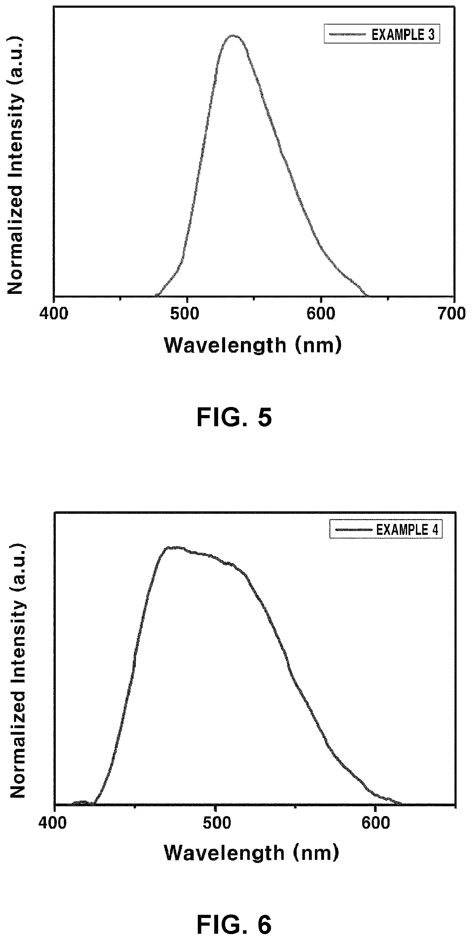

As confirmed in FIG. 5, the phosphor according to Example 3 of the invention exhibited a light emission wavelength of 555 nm for an excitation light of 450 nm. That is, since light is emitted in the range of a green color wavelength, it can be seen that the phosphor may be applied as a green phosphor.

As confirmed in FIG. 6, the phosphor according to Example 4 of the present invention exhibited a light emission wavelength of 555 nm for an excitation light of 450 nm. That is, since light is emitted in the range between a green color wavelength and a blue color wavelength, it can be seen that the phosphor may be used for tuning the above color wavelength region.

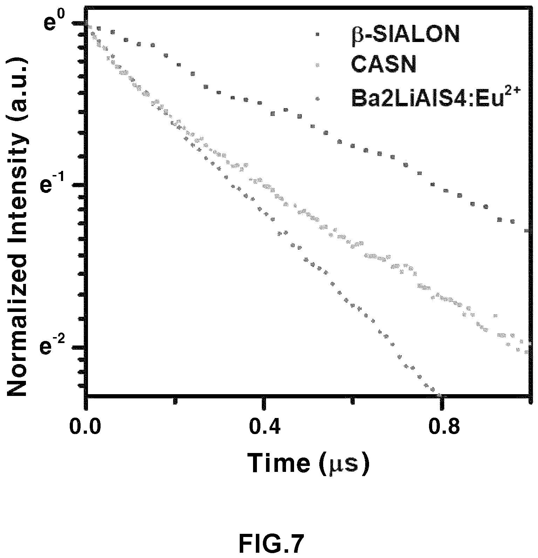

FIG. 7 shows the attenuation rate of the phosphor produced according to Example 1 of the invention compared with the attenuation rate of other commercial phosphors, B-SIALON and CASN.

As shown in FIG. 7, it can be confirmed that the phosphor according to Example 1 of the invention has a very high attenuation rate compared to a typically available phosphor. Therefore, the phosphor according to the invention does not cause the problem of residual light due to a slow attenuation rate when applied to a light-emitting element of LED elements, white LEDs, displays, and the like.

The present invention is not limited by the above-described embodiments and the accompanying drawings, but is intended to be limited by the appended claims. Accordingly, various types of substitutions, modifications, and changes may be made by those skilled in the art within the scope not departing from the claims.

This research was supported by Creative Materials Discovery Program through the National Research Foundation of Korea (NRF) funded by Ministry of Science and ICT (Project No.: 20150899, Project name: Discovery of inorganic functional materials using heuristics-based computation)

## Claims

1. A sulfide phosphor comprising
a parent body containing one or more selected from Ba, Li, and S, and Al and Ga as a constituent element, wherein one or more activators selected from Eu and Ce are employed to the parent body.

2. The sulfide phosphor of Claim 1,
wherein when the relative intensity of a diffraction peak having the highest intensity in a powder X-ray diffraction pattern is set to 100%, the parent body comprises a phase showing a diffraction peak of 5% or more of the relative intensity in a range in which the Bragg angle (2θ) of the X-ray diffraction pattern is 17.4° to 18.4°, 24.7° to 25.7°, 28.5° to 29.5°, 31.2° to 32.2°, 33.5° to 34.5°, and 35.5° to 36.5° as a main phase.

3. The sulfide phosphor of Claim 1 or 2,
wherein the phosphor is composed of [Composition Equation 1] below:
[Composition Equation 1] BaₐLi_{b}A_{C}Sₓ : Ln_{z}
(wherein 0.5≤a≤2, 0.5≤b≤1.5, 0.5≤c≤1.5, 2.5≤x≤7.5, and 0.001≤z/a≤0.2, A is one or more selected from Al and Ga, and Ln is an activator).

4. The sulfide phosphor of Claim 2 or 3,
wherein the lattice constant of the main phase of the parent body is a = 8.212 a, b = 6.951 a, and c = 7.186 a, and the lattice constants may vary by ± 5%.

5. The sulfide phosphor of one of Claims 2 to 4, wherein the main phase of the parent body has a monoclinic crystal structure.

6. The sulfide phosphor of one of Claims 2 to 5, wherein the molar ratio of Ba:Li:A:S in the parent body is 2:1:1:4.

7. The sulfide phosphor of one of Claims 1 to 6, wherein the phosphor has a light emission wavelength of 465 to 600 nm for an excitation wavelength of 300 to 470 nm.

8. The sulfide phosphor of one of Claims 1 to 7, wherein the phosphor emits a green light or a cyan light.

9. The sulfide phosphor of one of Claims 1 to 8, wherein the phosphor is made of a powder having an average particle size of 1 to 20 µm.

10. A light-emitting device comprising a sulfide phosphor and comprising:
a light-emitting element which emits excitation light; and
a wavelength-converting unit which absorbs the excitation light and emits visible light,
wherein the wavelength-converting unit includes a parent body containing one or more selected from Ba, Li, and S, and Al and Ga as a constituent element, wherein one or more activators selected from Eu and Ce are employed to the parent body.

11. The light-emitting device of Claim 10, wherein the light-emitting element is an ultraviolet light-emitting diode and a blue light-emitting diode.

12. The light-emitting device of Claim 10 or 11, wherein the sulfide phosphor is further configured according to one of claims 2 to 9.
